# EUROPEAN PATENT APPLICATION

(11) **EP 2 273 858 A1**
(43) Date of publication of application: **12.01.2011**
(21) Application number: 10167409.1
(22) Date of filing: 25.06.2010
(51) Int. Cl.: H05K 3/36, H05K 1/14

(54) **Printed circuit board unit and electronic device**

(30) Priority: 10.07.2009 JP 2009164034
(71) Applicant: FUJITSU LIMITED, Kawasaki-shi, Kanagawa 211-8588 (JP)
(72) Inventor: Takada, Rie, Kawasaki-shi Kanagawa 211-8588 (JP); Tsubone, Kenichiro, Kawasaki-shi Kanagawa 211-8588 (JP)
(74) Representative: Fenlon, Christine Lesley

(57) **Abstract**

A printed circuit board unit includes a printed circuit board (11) including through holes (20) arranged in a grid array on which an integrated circuit (12) is mounted; and a flexible substrate (15) provided on a back side of the printed circuit board, covering the through holes. First lands (36) to which the integrated circuit is connected are formed on a front side of the printed circuit board. Second lands (37) to which the flexible substrate is connected are formed on the back side of the printed circuit board. The first lands and the second lands are connected to first ends and second ends of the through holes, respectively. Third lands (38) are formed on a front side of the flexible substrate so as to face the second lands of the printed circuit board. Fourth lands (39) are formed on a back side of the flexible substrate. The fourth lands are electrically connected to the third lands.

## Description

### FIELD

The embodiments discussed herein are related to a printed circuit board unit and an electronic device.

### BACKGROUND

A printed circuit board unit is formed by mounting electronic components on a printed circuit board. Examples of electronic components are an integrated circuit, a resistor, and a capacitor. In recent years, integrated circuits have become increasingly multi-function and high performance, and therefore a large number of components are being mounted on a printed circuit board. Furthermore, electronic devices with such a built-in printed circuit board unit are becoming increasingly compact. Therefore, there is demand for compact printed circuit board units. Accordingly, components are being increasingly densely mounted in the printed circuit board unit. Hence, it is becoming difficult to secure enough space on the printed circuit board for mounting multiple components. One approach is to provide a printed circuit board unit in which electronic components may be mounted not only on the front side but also on the back side (see, for example, Japanese Laid-Open Patent Application No. 2000-150775).

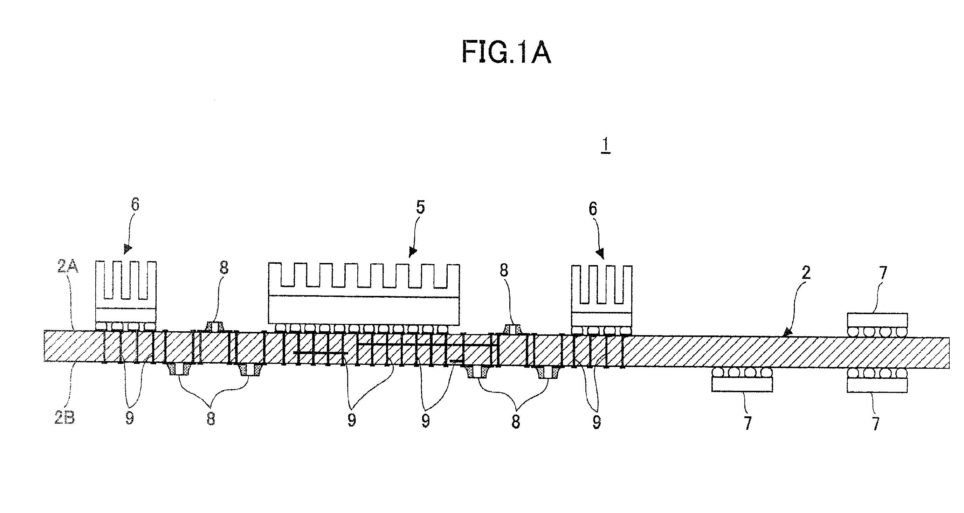

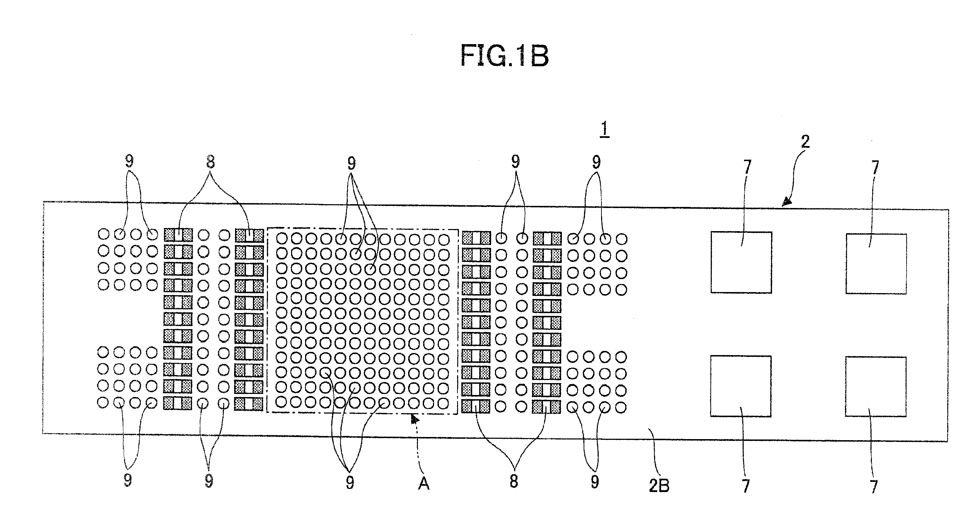

FIGS. 1A and 1B illustrate an example of a conventional printed circuit board unit 1. FIG. 1A is a cross-sectional view of the printed circuit board unit 1, and FIG. 1B is a bottom view of the printed circuit board unit 1. The printed circuit board unit 1 includes a printed a circuit board 2 having a front side 2A and a back side 2B. Electronic components such as a BGA (ball grid array) type integrated circuit 5, a BGA type memory 6, a memory 7, and a bypass capacitor 8 are mounted on the front side 2A of the printed circuit board 2. The memory 7 and the bypass capacitor 8 are also mounted on the back side 2B of the printed circuit board 2.

The components mounted on the front side 2A of the printed circuit board 2 and the components mounted on the back side 2B of the printed circuit board 2 are electrically connected to each other by through holes 9 formed in the printed circuit board 2. A method other than using through holes 9 may be applied to electrically connect the components mounted on the front side 2A of the printed circuit board 2 and the components mounted on the back side 2B of the printed circuit board 2. For example, a built-up substrate may be used as the printed circuit board 2, so that the components are electrically connected to each other by interlayer wiring and via holes that are formed in the built-up substrate.

However, the operation of forming interlayer wiring and via holes entails complex procedures and increased cost. Therefore, through holes are preferably used for connecting the components in terms of simplifying the manufacturing process and reducing cost.

The through holes 9 are arranged in a grid array in the printed circuit board 2. Furthermore, the through holes 9 are densely formed in the printed circuit board 2 in a region where the BGA type integrated circuit 5 is provided.

In FIG. 1B, the region indicated by an arrow A that is surrounded by a dashed-dotted line is where the through holes 9 corresponding to the BGA type integrated circuit 5 are formed (hereinafter, "high density formation region A"). In the high density formation region A, the through holes 9 are densely formed. However, in the high density formation region A, it may be difficult to form chip components such as a bypass capacitor or a termination resistor.

Therefore, in a conventional structure for mounting components, this high density formation region A becomes a so called dead space that may not be used for mounting components. Hence, in a conventional structure, it is difficult to densely mount components on the printed circuit board.

### SUMMARY

Accordingly, it is an object in one aspect of the invention to provide a printed circuit board unit and an electronic device, with which components may be densely mounted on a printed circuit board.

According to an aspect of the invention, a printed circuit board unit includes a printed circuit board including through holes arranged in a grid array on which an integrated circuit is mounted; and a flexible substrate provided on a back side of the printed circuit board in such a manner as to cover the through holes, wherein first lands to which the integrated circuit is connected are formed on a front side of the printed circuit board, the first lands being connected to first ends of the through holes, second lands to which the flexible substrate is connected are formed on the back side of the printed circuit board, the second lands being connected to second ends of the through holes, third lands are formed on a front side of the flexible substrate so as to face the second lands of the printed circuit board, and fourth lands are formed on a back side of the flexible substrate, the fourth lands being electrically connected to the third lands.

### BRIEF DESCRIPTION OF THE DRAWINGS

FIGS. 1A and 1B illustrate an example of a conventional printed circuit board unit;
FIGS. 2A through 2C are for describing a printed circuit board unit according to a first embodiment of the present invention;
FIG. 3 is an exploded view of a region in FIG. 2A indicated by an arrow B that is surrounded by a dashed-dotted line;
FIG. 4 is a cross-sectional view of the printed circuit board unit according to the first embodiment of the present invention while a rework process is performed on the BGA type integrated circuit;
FIG. 5 is an enlarged cross-sectional view of the printed circuit board unit according to the first embodiment of the present invention while a rework process is performed on a BGA type memory;
FIG. 6 is a cross-sectional view of the printed circuit board unit according to a modification of the first embodiment;
FIG. 7 is a cross-sectional view of an assembly in which printed circuit board units illustrated in FIG. 6 are laminated to each other;
FIG. 8A through 8C are for describing a method of fabricating the printed circuit board unit according to the first embodiment (part 1);
FIG. 9A through 9C are for describing the method of fabricating the printed circuit board unit according to the first embodiment (part 2);
FIG. 10A through 10D are for describing the method of fabricating the printed circuit board unit according to the first embodiment (part 3);
FIG. 11A and 11B are for describing the method of fabricating the printed circuit board unit according to the first embodiment (part 4);
FIG. 12A and 12B are for describing the method of fabricating the printed circuit board unit according to the first embodiment (part 5);
FIG. 13 is for describing the method of fabricating the printed circuit board unit according to the first embodiment (part 6);
FIG. 14A through 14E are for describing another method of fabricating the printed circuit board unit according to the first embodiment;
FIGS. 15A through 15C are for describing a printed circuit board unit according to a second embodiment of the present invention;
FIG. 16A and 16B illustrates a rigid flexible substrate serving as a slave substrate in the printed circuit board unit according to the second embodiment; and
FIGS. 17A through 17C illustrate various flexible substrates that are applicable to the printed circuit board unit according to the second embodiment.

### DESCRIPTION OF EMBODIMENTS

A description is given, with reference to the accompanying drawings, of embodiments of the present invention.

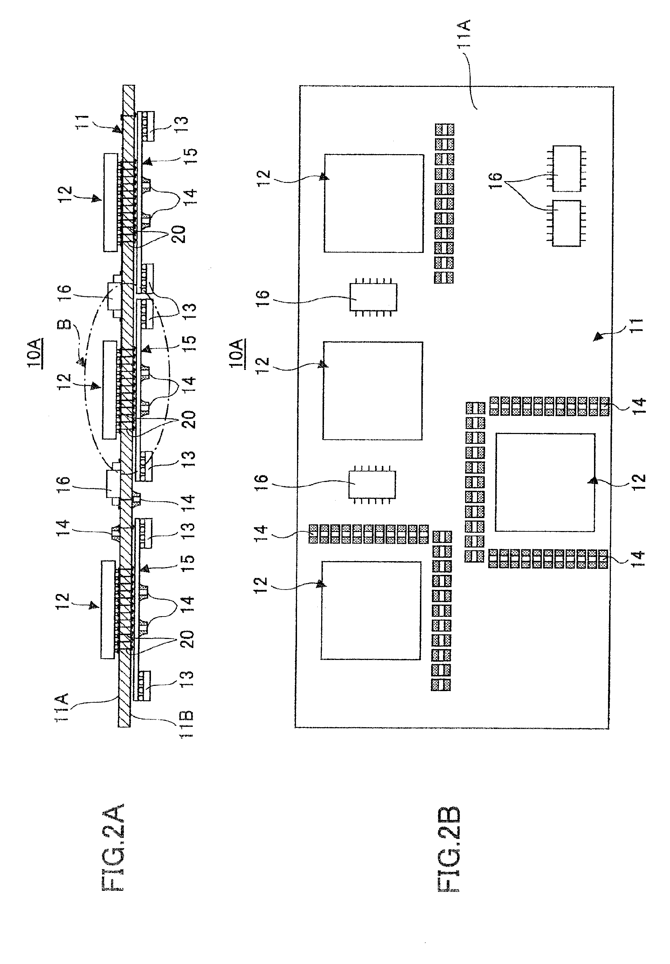

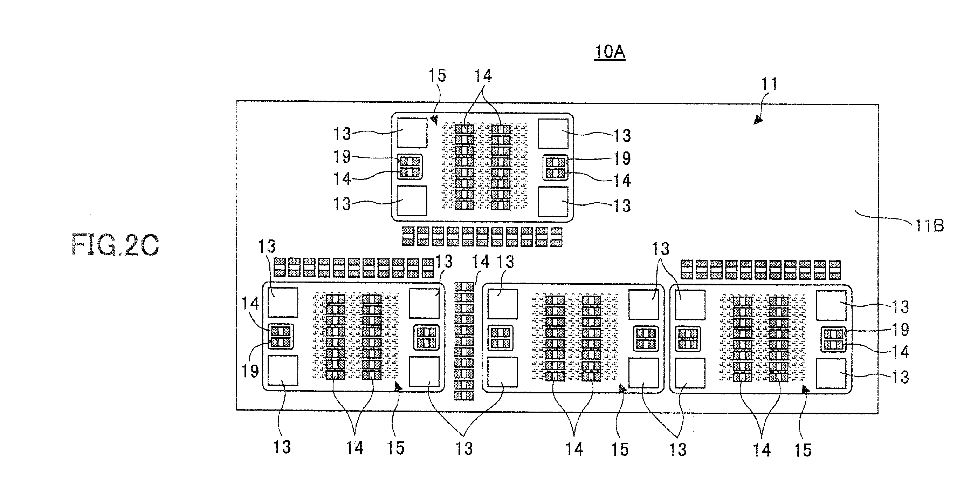

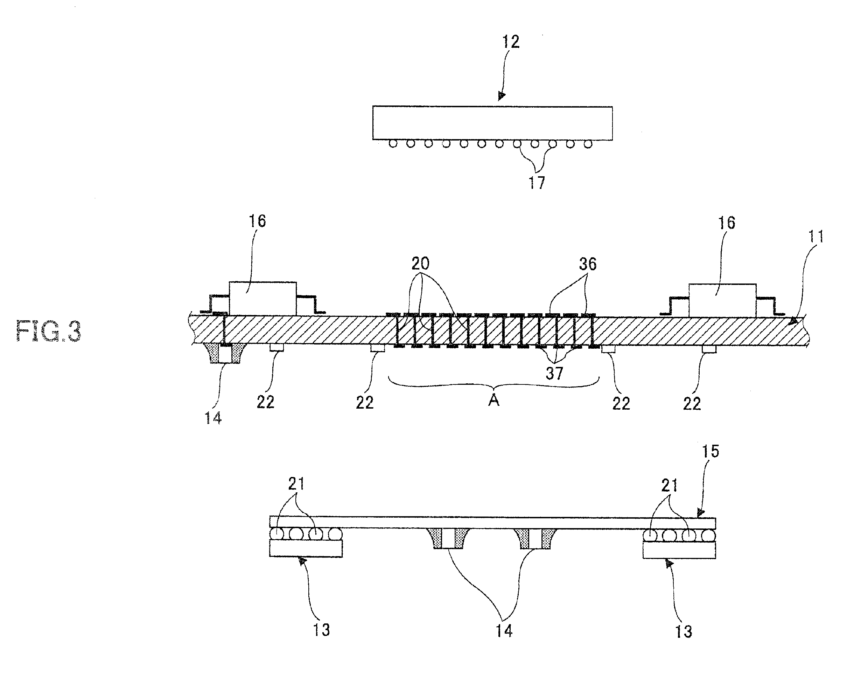

FIGS. 2A through 3 are for describing a printed circuit board unit 10A according to a first embodiment of the present invention. FIG. 2A is a cross-sectional view of the printed circuit board unit 10A, FIG. 2B is a top view of the printed circuit board unit 10A, and FIG. 2C is a bottom view of the printed circuit board unit 10A. FIG. 3 is an exploded view of a region in FIG. 2A indicated by an arrow B that is surrounded by a dashed-dotted line.

The printed circuit board unit 10A includes a printed circuit board 11, EGA type integrated circuits 12, EGA type memories 13, bypass capacitors 14, a flexible substrate 15, and SOP type transformers 16. In the printed circuit board unit 10A according to the present embodiment, electronic components on the front side and electronic components on the back side are electrically connected by through holes 20 that are arranged in a grid array.

The BGA type integrated circuit 12 is for performing various control processes in a server. A BGA (Ball Grid Array) package having a surface-mount structure is applied as the BGA type integrated circuit 12. Solder balls 17 are used as electrodes in the BGA type integrated circuit 12. The solder balls 17 are connected to first lands 36 (see FIG. 3) that are arranged on the printed circuit board 11, for mounting the BGA type integrated circuit 12 on the printed circuit board 11.

The first lands 36 are connected to the through holes 20 formed in the printed circuit board 11. The through holes 20 are formed by plating the insides of through holes that are formed so as to pierce through the printed circuit board 11. The first lands 36 are formed at the top ends of the through holes 20. Furthermore, electrode pads are formed at the bottom ends of the through holes 20. The electrode pads are for connecting the printed circuit board 11 to the flexible substrate 15.

The through holes 20 are arranged in a grid array in the region where the BGA type integrated circuit 12 is mounted. Hereinafter, the region where the through holes 20 are formed and the BGA type integrated circuit 12 is mounted is referred to as the high density formation region A. Furthermore, the electrode pads formed in the high density formation region A are referred to as second lands 37.

In the present embodiment, four BGA type integrated circuits 12 are mounted on the printed circuit board 11, as illustrated in FIG. 2B. Thus, in the printed circuit board unit 10A according to the present embodiment, four high density formation regions A are formed at positions where the BGA type integrated circuits 12 are formed.

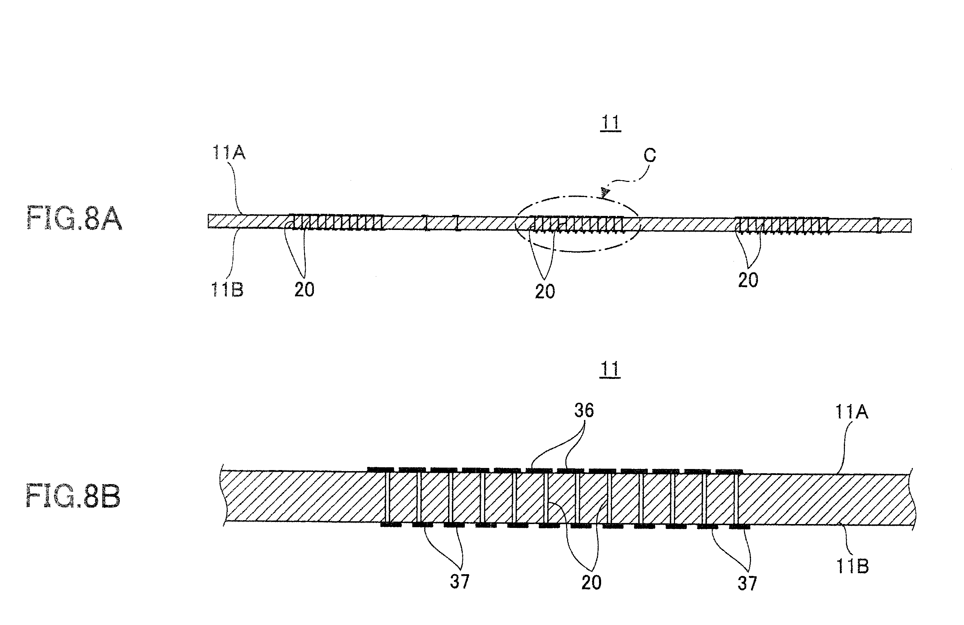

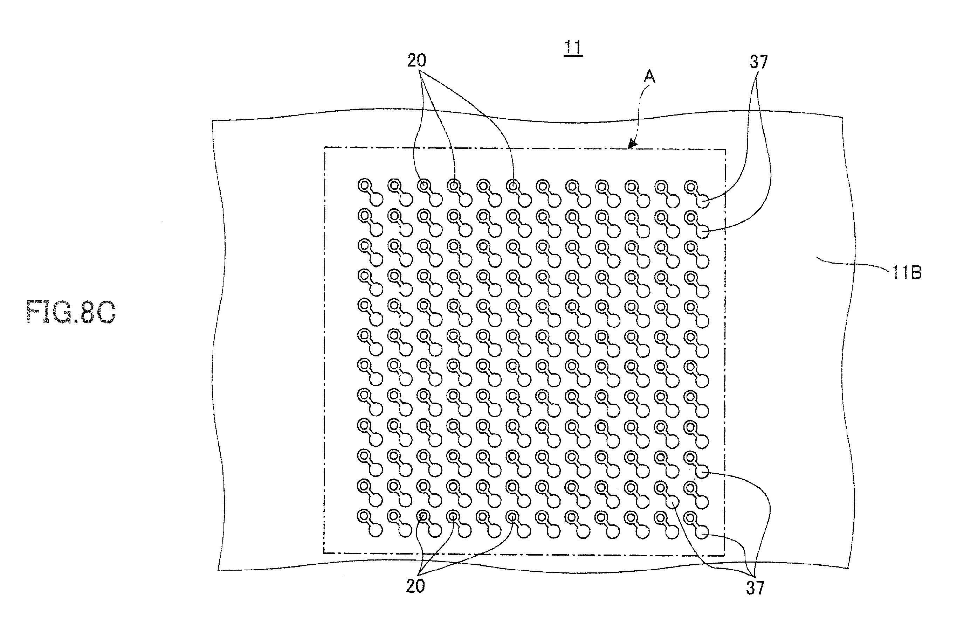

FIG. 8C is an enlarged view of the high density formation region A as viewed from the bottom of the printed circuit board 11. As illustrated in FIG. 8C, the second lands 37 are densely formed in the high density formation region A as viewed from a back side 11B of the printed circuit board 11. The second lands 37 correspond to the through holes 20, and are used for connecting the printed circuit board 11 to the flexible substrate 15. As described above, in the high density formation region A on the back side 11B of the printed circuit board 11, it is difficult to densely mount components such as chip components and electronic components.

The BGA type memory 13 is, for example, a buffer memory. The BGA type memory 13 is typically preferably disposed near the BGA type integrated circuit 12 for the purpose of increasing the processing speed of the BGA type integrated circuit 12. However, the BGA type memory 13 may be affected by heat from the high-heat-generating BGA type integrated circuit 12. In order to prevent this, there are cases where the BGA type memory 13 is provided with radiating fins. However, in the present embodiment, the BGA type memory 13 is electrically connected to the BGA type integrated circuit 12 via the flexible substrate 15. Therefore, the BGA type memory 13 is prevented from being affected by heat from the high-heat-generating BGA type integrated circuit 12, without providing radiating fins. Furthermore, when reworking is performed due to loose connection of the BGA type integrated circuit 12, the entire flexible substrate 15 that is a slave substrate may be removed, so that the BGA type memory 13 is prevented from being heated.

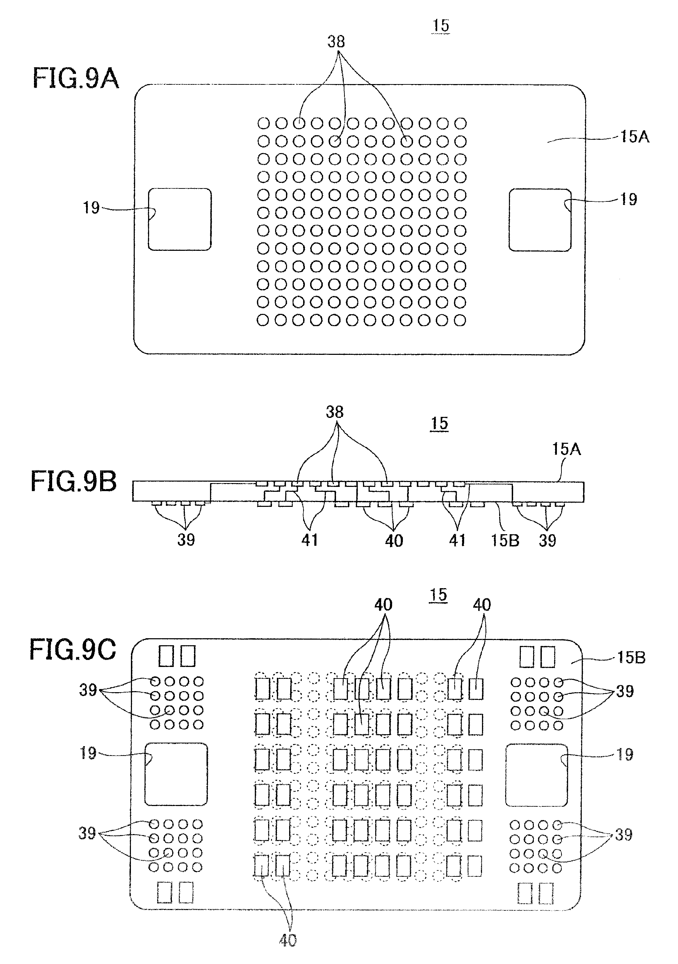

Next, a description is given of the flexible substrate 15 that is a slave substrate, with reference to FIGS. 9A through 9C. The flexible substrate 15 is a substrate for mounting electronic components, which is made of a resin film (for example, a polyimide film) that has insulation properties and flexibility. On a front side 15A of the flexible substrate 15, third lands 38 are formed for connecting the flexible substrate 15 to the printed circuit board 11. The third lands 38 are formed in such a manner as to face the second lands 37. Meanwhile, on a back side 15B of the flexible substrate 15, fourth lands 39 and 40 are formed for mounting electronic components on the back side 15B of the flexible substrate 15. The fourth lands 39 and 40 are electrically connected to the third lands 38.

The third lands 38, which are for connecting to the printed circuit board 11, are connected to the second lands 37 of the printed circuit board 11 by soldering. Accordingly, the flexible substrate 15 is fixed to the printed circuit board 11.

The fourth lands 39 and 40 for mounting electronic components are formed on the back side 15B of the flexible substrate 15. The BGA type memory 13 is connected to the fourth lands 39 formed in an extending part 48B (described below) of the flexible substrate 15, and the bypass capacitor 14 is connected to the fourth lands 40 that are formed facing the high density formation region A. Wiring patterns 41 are connected to the third lands 38 for connecting to the printed circuit board 11 formed on the front side 15A, and also to the fourth lands 39 and 40 that are formed on the back side 15B. In the present embodiment, an opening 19 is formed on either side of the flexible substrate 15. Some of the third lands 38 are electrically connected to the fourth lands 39 and 40. As illustrated in FIG. 9C, the back side 15B of the flexible substrate 15 has sufficient space for lands used for mounting electronic components such as the BGA type memory 13, the bypass capacitor 14, and termination resistors. The fourth lands 40 on which the bypass capacitor 14 is mounted are arranged at a pitch that is larger than that of the third lands 38 formed on the front side 15A of the flexible substrate 15.

The flexible substrate 15 is disposed at a position on the back side 11B of the printed circuit board 21, in such a manner as to correspond to the position where the BGA type integrated circuit 12 is mounted on the other side of the printed circuit board 11.

The size of the flexible substrate 15 is the same as or larger than that of the high density formation region A formed on the printed circuit board 11. In the present embodiment, the size of the flexible substrate 15 as viewed from the top is larger than that of the high density formation region A formed on the printed circuit board 11. Therefore, the flexible substrate 15 is located in a region where the BGA type integrated circuit 12 is mounted on the front side 11A of the printed circuit board 11 (i.e., in the high density formation region A). As described above, in the present embodiment, there are four BGA type integrated circuits 12 provided on the front side 11A of the printed circuit board 11. Accordingly, there are four flexible substrates 15 provided on the back side 11B of the printed circuit board 11, in such a manner as to correspond to the positions where the BGA type integrated circuits 12 are formed.

Accordingly, in the printed circuit board unit 10A to which the mounting structure according to the present embodiment is applied, electronic components such as the bypass capacitor 14 may be mounted in the high density formation region A. As components are densely mounted in the present embodiment, the printed circuit board unit 10A is made compact, thus reducing the size of an electronic device such as a server in which the printed circuit board unit 10A is installed.

Furthermore, the BGA type memory 13 may be mounted at a position corresponding to the position where the BGA type integrated circuit 12 is mounted on the printed circuit board 11. Accordingly, the length of wiring between the BGA type integrated circuit 12 and the BGA type memory 13 is short. Hence, signals are exchanged between the BGA type integrated circuit 12 and the BGA type memory 13 at high speed, thus enhancing the reliability of the printed circuit board unit 10A.

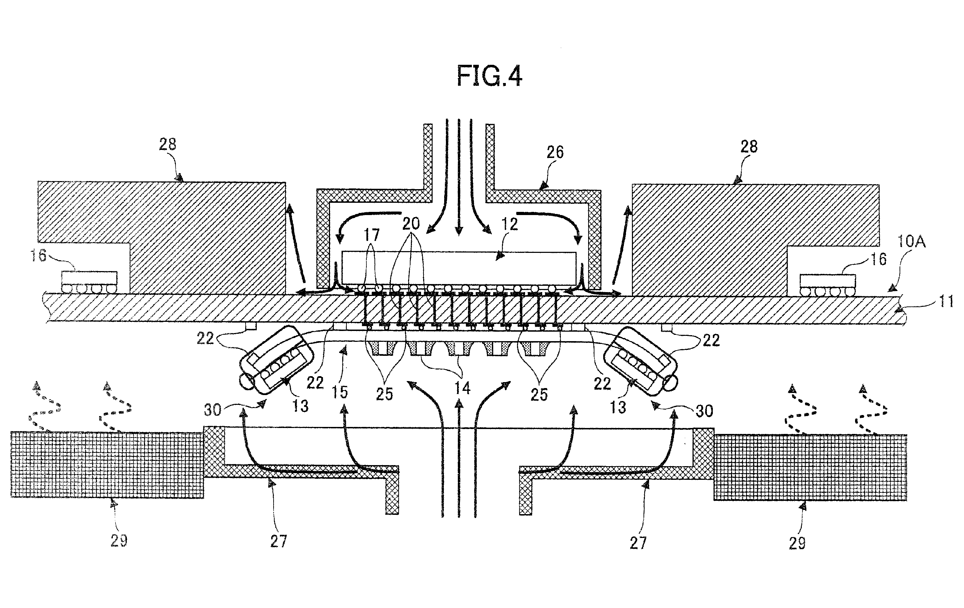

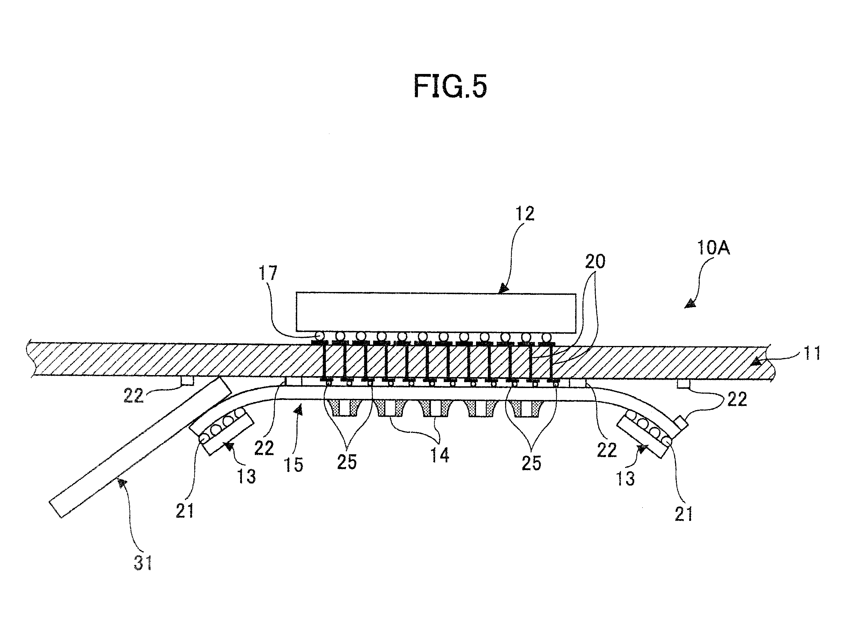

FIGS. 4 and 5 illustrate a state where a rework process is performed on the printed circuit board unit 10A. FIG. 4 illustrates an example of performing rework due to a performance failure or loose connection of the BGA type integrated circuit 12 mounted on the printed circuit board 11. FIG. 5 illustrates an example of performing rework due to a failure in the BGA type memory 13 of the flexible substrate 15.

First, a description is given of a reworking method performed on the BGA type integrated circuit 12, with reference to FIG. 4. Before removing the BGA type integrated circuit 12 from the printed circuit board 11, a top heating cover 26 for covering the BGA type integrated circuit 12 is disposed on the front side 11A of the printed circuit board 11. Additionally, heat-proof jigs 28 are disposed on the front side 11A of the printed circuit board 11 for preventing the transformers 16 located near the BGA type integrated circuit 12 from being affected by heat. Furthermore, a bottom heating cover 27 is disposed on the back side 11B of the printed circuit board 11, in such a manner as to correspond to the position where the BGA type integrated circuit 12 is mounted. Additionally, heating plates 29 are disposed on the back side 11B of the printed circuit board 11 in such a manner as to surround the bottom heating cover 27.

The top heating cover 26 is connected to a hot air supplying means (not illustrated) that supplies hot air indicated by arrows. The hot air supplied from this hot air supplying means to the top heating cover 26 is hot enough for melting the solder balls 17. As the solder balls 17 melt, the BGA type integrated circuit 12 may be removed from the printed circuit board 11. The transformers 16 mounted adjacent to the BGA type integrated circuit 12 are protected by the heat-proof jigs 28, and are thus prevented from being damaged by the hot air supplied from the hot air supplying means.

The bottom heating cover 27 is for heating the back side 11B of the printed circuit board 11. Similar to the top heating cover 26, hot air indicated by arrows is supplied to the bottom heating cover 27 from a hot air supplying unit. Furthermore, the heating plates 29 are also for heating the back side 11B of the printed circuit board 11. The bottom heating cover 27 and the heating plates 29 are for preheating the printed circuit board 11. By preheating the printed circuit board 11, the inside of the top heating cover 26 may be quickly heated to a temperature high enough for melting the solder balls 17, thereby enhancing the efficiency of rework.

In the printed circuit board unit 10A according to the present embodiment, the BGA type memories 13 are mounted near the outer periphery of the flexible substrate 15 (the extending part 48B described below). These BGA type memories 13 may be damaged due to heat while rework is performed on the BGA type integrated circuit 12.

To prevent such a problem, fixing resin 22 is removed during the rework process. The fixing resin 22 is used for fixing the parts near the outer periphery of the flexible substrate 15 to the back side 11B of the printed circuit board 11. By removing the fixing resin 22, the regions of the flexible substrate 15 where the BGA type memories 13 are mounted are separated from the printed circuit board 11. Furthermore, the BGA type memories 13 are covered with heat proof covers 30. Accordingly, the BGA type memories 13 are prevented from being damaged by heat while rework is performed on the BGA type integrated circuit 12. Hence, the rework process on the BGA type integrated circuit 12 may be reliably performed, even if the flexible substrate 15 is used for enhancing the efficiency in mounting components in the printed circuit board unit 10A.

FIG. 5 illustrates a rework process on the BGA type memories 13 mounted on the flexible substrate 15. As described above, the BGA type memories 13 are mounted near the outer periphery of the flexible substrate 15. Accordingly, in order to perform rework on the BGA type memories 13, the regions where the BGA type memories 13 are mounted on the flexible substrate 15 are separated from the printed circuit board 11 by removing the fixing resin 22. Then, a heating jig 31 is brought in contact with these portions (where the flexible substrate 15 is separated from the printed circuit board 11), to heat solder balls 21 to a melting temperature. Thus, the BGA type memories 13 may be removed from the flexible substrate 15 without using the top heating cover 26, the bottom heating cover 27, the heat-proof jigs 28, or the heating plates 29 as in the case of performing rework on the BGA type integrated circuit 12.

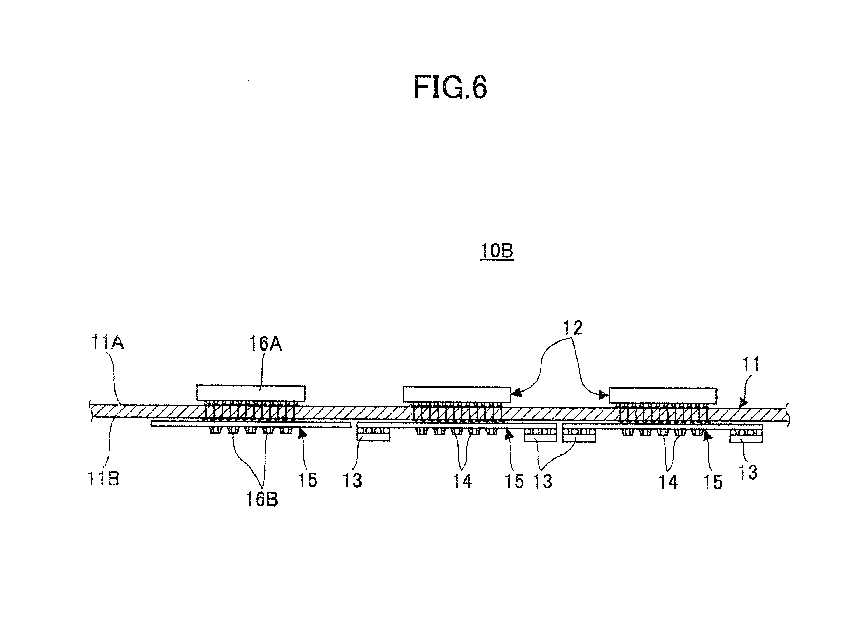

FIG. 6 illustrates a printed circuit board unit 10B, which is a modification of the printed circuit board unit 10A according to the first embodiment. In the printed circuit board unit 10B according to the present modification, a group of high-heat-generating components are mounted on the front side 11A of the printed circuit board 11, and a group of low-heat-generating components are mounted on the back side 11B of the printed circuit board 11 via the flexible substrate 15.

The BGA type integrated circuit 12 is a semiconductor device for performing various control processes in the server in which the printed circuit board unit 10B is installed. Accordingly, the BGA type integrated circuit 12 performs high-speed processing and generates high heat during operation. Furthermore, a transformer 16A mounted on the front side 11A of the printed circuit board 11 also generates high heat during operation. Hence, the group of high-heat-generating components that generate high heat during operation, such as the BGA type integrated circuit 12 and the transformer 16A, are densely mounted on the front side 11A of the printed circuit board 11.

Conversely, the BGA type memory 13 does not generate high heat during operation like the BGA type integrated circuit 12. Similarly, a bypass capacitor 16B mounted on the back side 11B of the printed circuit board 11 does not generate high heat during operation. The group of low-heat-generating components that do not generate high heat during operation such as the BGA type memories 13 and the bypass capacitor 16B are densely mounted on the back side 11B of the printed circuit board 11 via the flexible substrate 15.

As described above, the group of high-heat-generating components and the group of low-heat-generating components are mounted separately from each other, i.e., on the front side 11A and the back side 11B of the printed circuit board 11, respectively. If these components were mounted on the same side of the printed circuit board 11, components for blocking heat would also need to be provided on the same side. However, in the present modification, there is no need to provide components for blocking heat, thus enhancing the efficiency in mounting components.

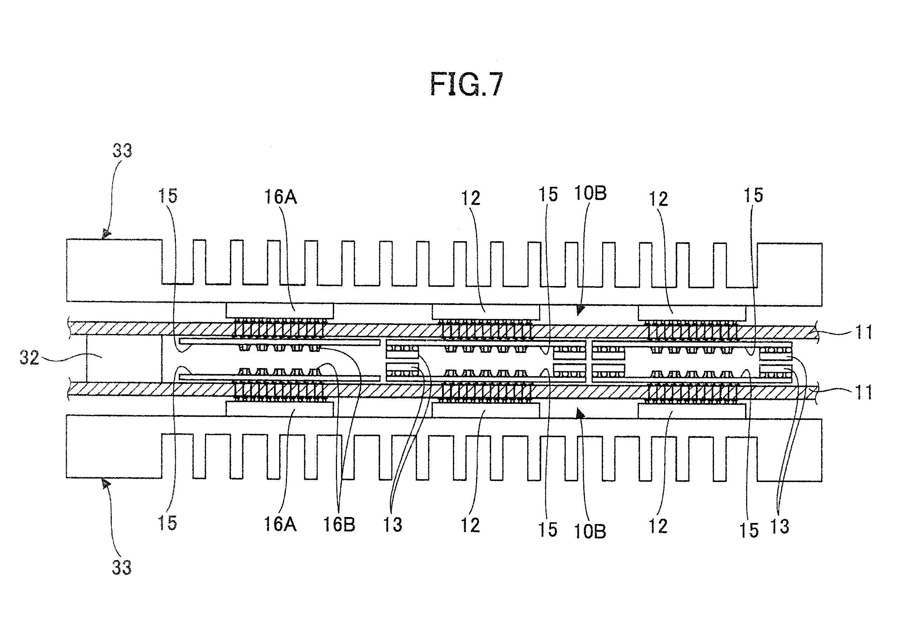

FIG. 7 illustrates an assembly in which two printed circuit board units 10B illustrated in FIG. 6 are laminated to each other. The top printed circuit board unit 10B includes a group of high-heat-generating components mounted on the top side of the printed circuit board 11 as viewed in FIG. 7, and a group of low-heat-generating components mounted on the bottom side of the printed circuit board 11 as viewed in FIG. 7.

The bottom printed circuit board unit 10B includes a group of low-heat-generating components mounted on the top side as viewed in FIG. 7, and a group of high-heat-generating components mounted on the bottom side as viewed in FIG. 7. Accordingly, the two laminated printed circuit board units 10B are arranged such that the sides with low-heat-generating components are facing each other. Furthermore, the two laminated printed circuit board units 10B are electrically connected by stag connectors 32. By laminating the printed circuit board units 10B in the above manner, the efficiency in mounting electric components is further enhanced.

Furthermore, the BGA type integrated circuits 12 that are high-heat-generating components in the printed circuit board unit 10A and the printed circuit board unit 10B may be provided with radiating fins 33 as illustrated in FIG. 7. The radiating fins 33 are made of a material having high thermal conductivity such as aluminum. The radiating fins 33 are fixed to the top side of the BGA type integrated circuits 12 with the use of an adhesive having high thermal conductivity.

Next, a description is given of a method of fabricating the printed circuit board unit 10A according to the first embodiment.

FIGS. 8A through 13 are for describing an example of a method of fabricating the printed circuit board unit 10A. To fabricate the printed circuit board unit 10A, the printed circuit board 11 illustrated in FIG. 8A through 8C and the flexible substrate 15 illustrated in FIGS. 9A through 9C are fabricated.

The printed circuit board 11 is a resin substrate including epoxy resin, and is a rigid substrate having a multilayer structure. The printed circuit board 11 is fabricated by a known method. At the position where the BGA type integrated circuit 12 is mounted, multiple through holes 20 are formed so as to correspond to the terminals of the BGA type integrated circuit 12.

The through holes 20 are formed by forming through holes in a resin substrate that is the base material, and then plating the insides of the through holes with copper. The first lands 36 are formed at the front ends of the through holes 20. The second lands 37 are formed at the back ends of the through holes for connecting the printed circuit board 11 to the flexible substrate 15. The first lands 36 and the second lands 37 may be formed together with or separately from the process of plating the through holes 20 with copper.

The flexible substrate 15 is fabricated by forming the third lands 38 for connecting the flexible substrate 15 to the printed circuit board 11 and the fourth lands 39 and 40 for mounting electronic components, on a resin film (for example, a polyimide film) having insulating properties and flexibility. The third lands 38 and the fourth lands 39 and 40 are formed by placing copper films on the polyimide film with the use of a printing technology.

Plural flexible substrates 15 are formed from a single polyimide film. Specifically, after forming the third lands 38 and the fourth lands 39 and 40, the polyimide film is cut into separate flexible substrates 15. The openings 19 may be formed at the same time as cutting the polyimide film into separate flexible substrates 15.

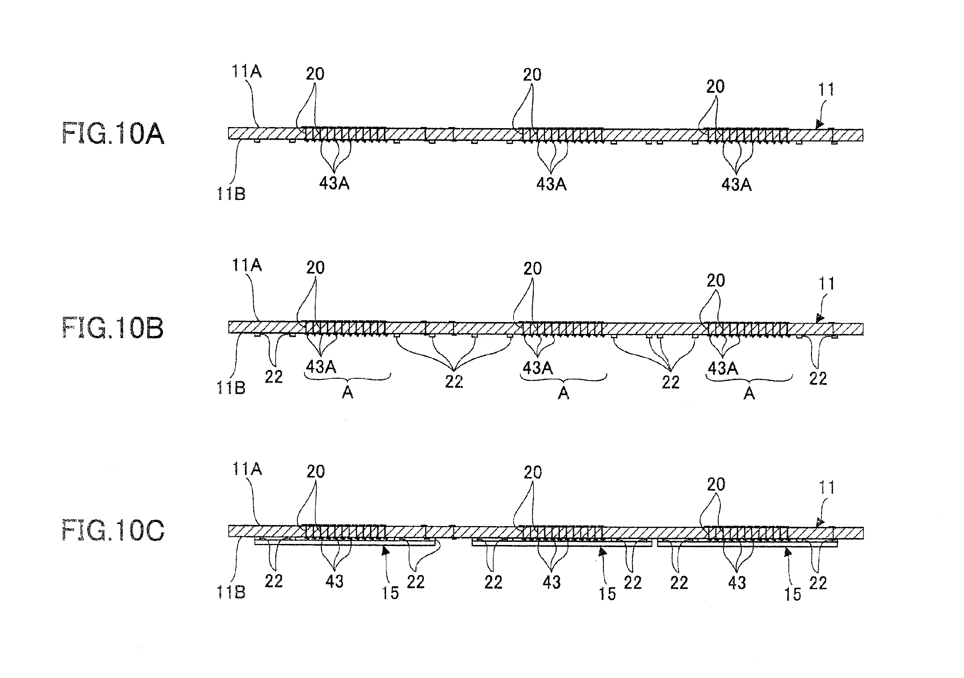

After the printed circuit board 11 and the flexible substrate 15 are formed in the above manner, as illustrated in FIG. 10A, solder paste 43A is applied to the positions where the second lands 37 for connecting to the flexible substrate 15 are formed, on the back side 11B of the printed circuit board 11. The solder paste 43A may be applied by, for example, a screen printing method.

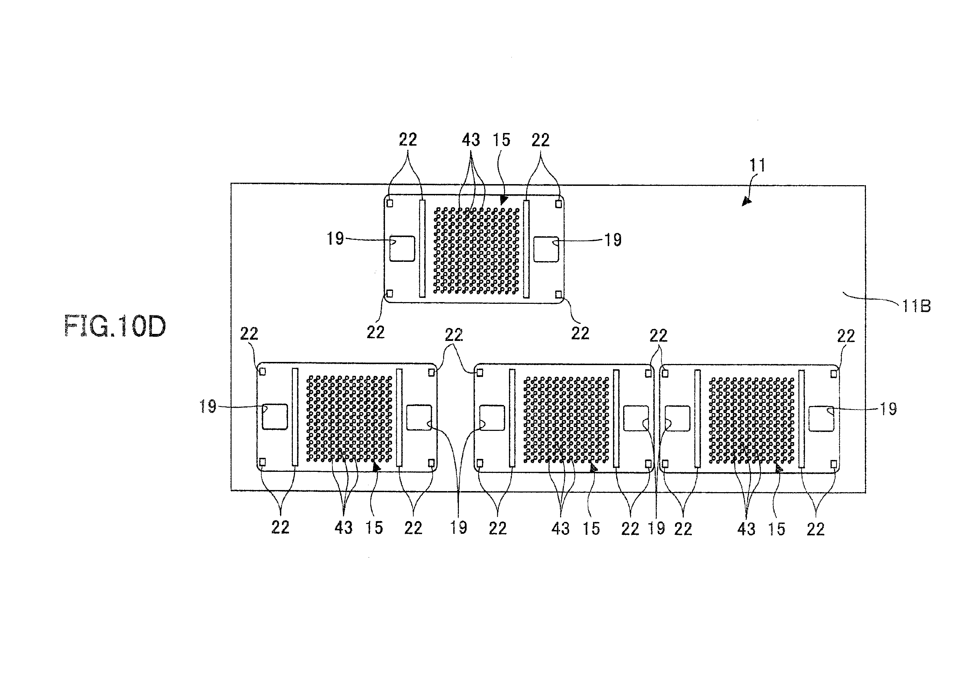

Next, as illustrated in FIG. 10B, the fixing resin 22 is applied to the back side 11B of the printed circuit board 11. The fixing resin 22 is applied in a linear manner along the sides of the high density formation region A, and is applied as points at positions corresponding to the four corners of the flexible substrate 15 (see FIG. 10D). The fixing resin 22 is thermosetting resin having viscosity. In response to heat, the fixing resin 22 is thermally-hardened and becomes adhesive.

After the solder paste 43A and the fixing resin 22 are applied on the back side 11B of the printed circuit board 11 as described above, the flexible substrates 15 are mounted on the back side 11B of the printed circuit board 11. The solder paste 43A contacts the third lands 38 of the flexible substrate 15, and the fixing resin 22 contacts the flexible substrate 15. As the fixing resin 22 has viscosity before being thermally-hardened, the flexible substrates 15 are tentatively fixed to the back side 11B of the printed circuit board 11 due to this viscosity.

Next, a reflow process is performed on the printed circuit board 11 on which the flexible substrates 15 have been tentatively fixed, in order to solder-mount the second lands 37 on the printed circuit board 11 onto the third lands 38 on the flexible substrate 15. Accordingly, the flexible substrate 15 is fixed onto the printed circuit board 21 by solder 43. The fixing resin 22 is also thermally-hardened in response to heat, and therefore the printed circuit board 11 and the flexible substrate 15 adhere to each other by the fixing resin 22.

As described above, the flexible substrates 15 are fixed on the printed circuit board 11 by the solder 43 and the fixing resin 22. FIG. 10C is a cross-sectional view of the printed circuit board 11 on which the flexible substrates 15 are fixed, and FIG. 10D is a bottom view of the same.

In the present embodiment, a transparent resin film is used as the flexible substrate 15. Therefore, the soldering positions where the solder 43 is applied and the adhering positions where the fixing resin 22 is applied may be directly viewed from the bottom of the printed circuit board 11 through the flexible substrate 15 that is a transparent resin film. Thus, soldering faults with the solder 43 and adhering faults with the fixing resin 22 may be easily and directly detected. Accordingly, the flexible substrate 15 may be connected and fixed to the printed circuit board 11 with high reliability.

In the present embodiment, the solder 43 is used for connecting the second lands 37 of the printed circuit board 11 to the third lands 38 of the flexible substrate 15. However, the method of connecting these substrates is not limited to soldering; a pressure bonding method or an ACF (Anisotropic Conductive Film) connecting method is also applicable.

When the flexible substrate 15 is disposed on the printed circuit board 11, solder paste (not illustrated) is applied to lands other than the second lands 37 that have been formed on the back side 11B of the printed circuit board 11 and to the fourth lands 39 and 40 formed on the back side 15B of the flexible substrate 15. The solder paste may be applied by a screen printing method. The flexible substrate 15 is a thin film (for example, 0.05 mm). Therefore, even if the flexible substrate 15 is disposed on the printed circuit board 11, it is possible to simultaneously perform screen printing on the printed circuit board 11 and screen printing for applying solder paste on the flexible substrate 15.

When the process of printing the solder paste is completed, electronic components such as the BGA type memories 13 and the bypass capacitors 14 are tentatively fixed to lands other than the second lands 37 on the back side 11B of the printed circuit board 11 and the fourth lands 39 and 40 on the back side 15B of the flexible substrate 15. Next, a reflow process is performed on the printed circuit board 11 on which the BGA type memories 13 and the bypass capacitors 14 have been tentatively fixed, in order to solder mount the electronic components such as the BGA type memories 13 and the bypass capacitors 14 onto the printed circuit board 11 and the flexible substrate 15.

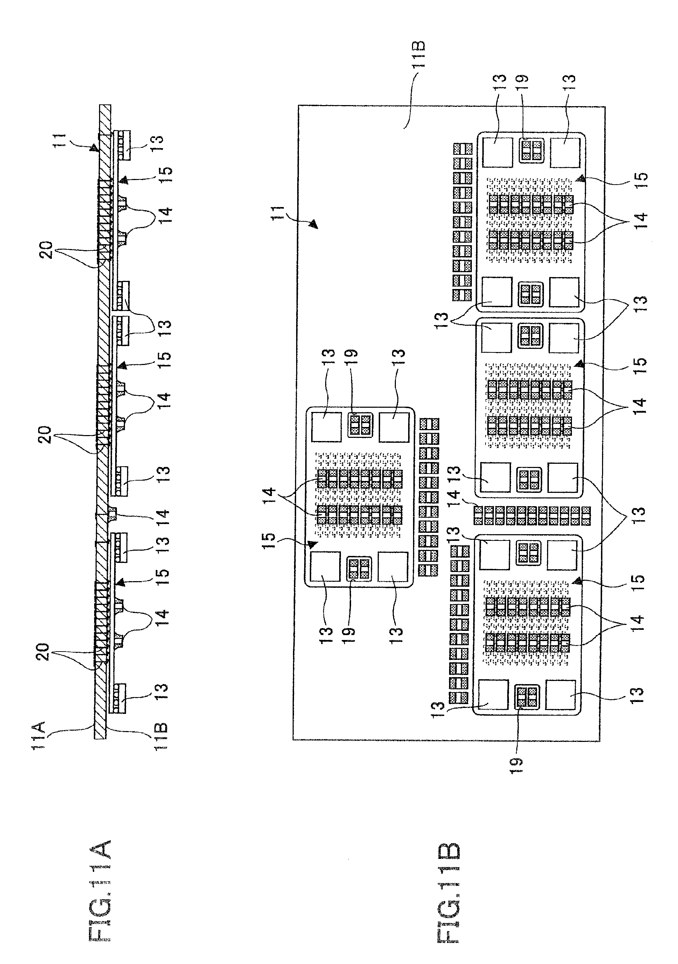

Accordingly, electronic components such as the BGA type memories 13 and the bypass capacitors 14 are mounted on the printed circuit board 11 and the flexible substrate 15. FIG. 11A is a cross-sectional view of electronic components such as the BGA type memories 13 and the bypass capacitors 14 being mounted on the back side 11B of the printed circuit board 11 and the flexible substrate 15, and FIG. 11B is a bottom view of the same.

After electronic components have been mounted on the back side 11B of the printed circuit board 11, electronic components are mounted on the front side 11A of the printed circuit board 11. That is to say, solder paste (not illustrated) is applied on the first lands 36 and lands for mounting the transformer 16, which are formed on the front side 11A of the printed circuit board 11. The solder paste may be applied by a screen printing method.

When the process of printing the solder paste is completed, electronic components such as the BGA type integrated circuits 12 and the transformers 16 are tentatively fixed to the first lands 36 and lands other than the first lands 36 on the front side 11A on the printed circuit board 11. Next, a reflow process is performed on the printed circuit board 11 on which the BGA type integrated circuits 12, etc., are tentatively fixed, in order to solder mount the electronic components such as the BGA type integrated circuits 12, etc., onto the printed circuit board 11.

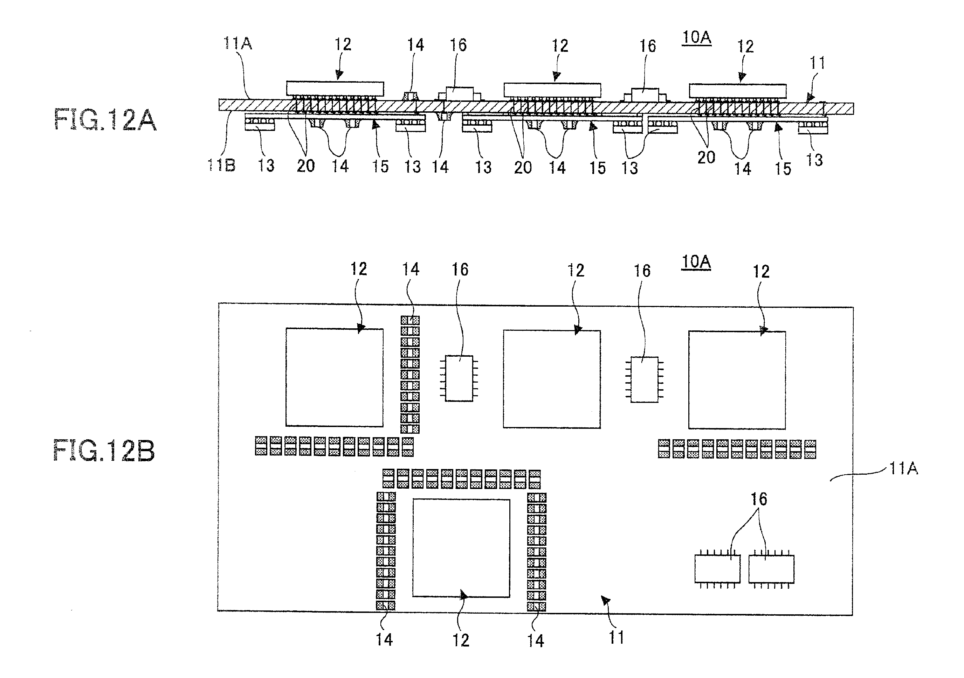

Accordingly, electronic components such as the BGA type integrated circuits 12, etc., are mounted on the printed circuit board 11. FIG. 12A is a cross-sectional view of electronic components such as the BGA type integrated circuits 12, etc., being mounted on the front side 11A of the printed circuit board 11, and FIG. 12B is a bottom view of the same.

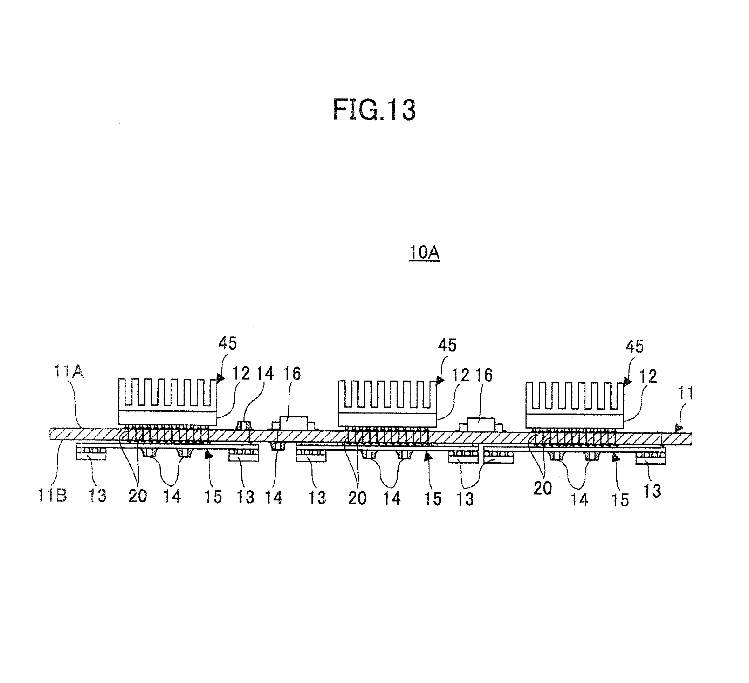

The printed circuit board unit 10A is fabricated by performing the above series of procedures. As the BGA type integrated circuit 12 generates a large amount of heat, radiating fins 45 may be provided on the BGA type integrated circuit 12 (see FIG. 13). The radiating fins 45 are preferably adhered to the BGA type integrated circuit 12 with the use of a thermal interface material (TIM) having high thermal conductivity.

Next, a description is given of a modification of the above-described method of fabricating the printed circuit board unit 10A.

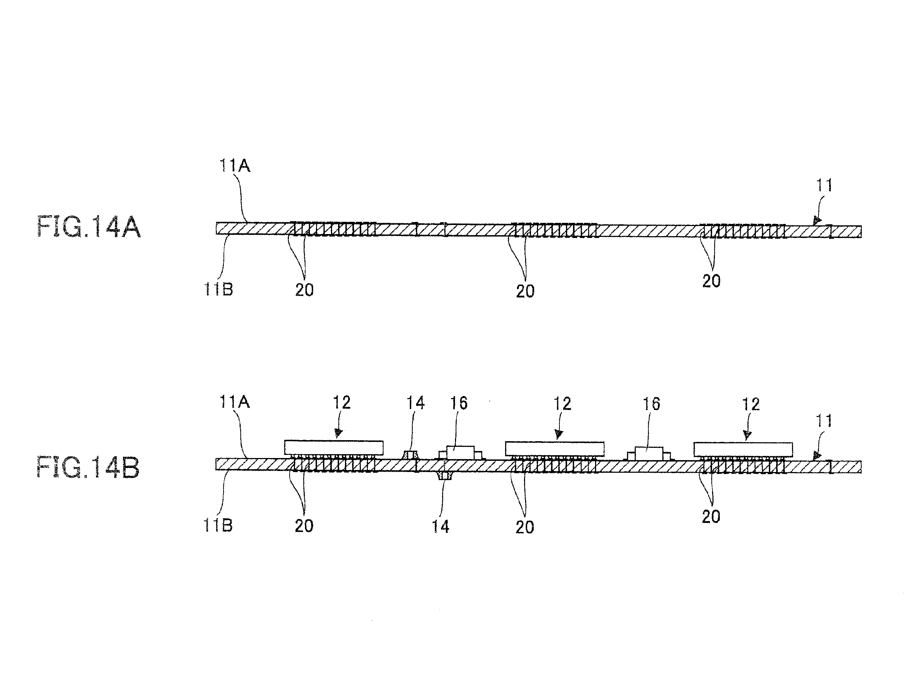

FIGS. 14A through 14E illustrate a method of fabricating the printed circuit board unit 10A according to the present modification. In FIGS. 14A through 14E, elements corresponding to those illustrated in FIGS. 8A through 13 are denoted by the same reference numerals and are not further described.

In the above-described method of fabricating the printed circuit board unit 10A, after the flexible substrates 15 are disposed on the printed circuit board 11, electronic components such as the BGA type integrated circuit 12 and the BGA type memories 13 are mounted on the printed circuit board 11 and the flexible substrate 15. In the present modification, before disposing the printed circuit boards 11 on the flexible substrate 15, the electronic components are mounted on each of the printed circuit board 11 and the flexible substrate 15. Then, the flexible substrates 15 on which the electronic components have been mounted are disposed on the printed circuit board 11 on which the electronic components have been mounted.

Specifically, on the printed circuit board 11 illustrated in FIG. 14A, solder paste is applied on the first lands 36 formed on the front side 11A and the second lands 37 formed on the back side 11B for connecting to the flexible substrate 15. Then, electronic devices such as the BGA type integrated circuits 12, the bypass capacitors 14, and the transformers 16 are tentatively fixed to the printed circuit board 11.

Next, a reflow process is performed on the printed circuit board 11 on which electronic components such as the BGA type integrated circuits 12 have been tentatively fixed, in order to solder-mount the electronic components such as the BGA type integrated circuits 12 onto the back side 11B of the printed circuit board 11. FIG. 14B illustrates the electronic components such as the BGA type integrated circuits 12 being mounted on the printed circuit board 11.

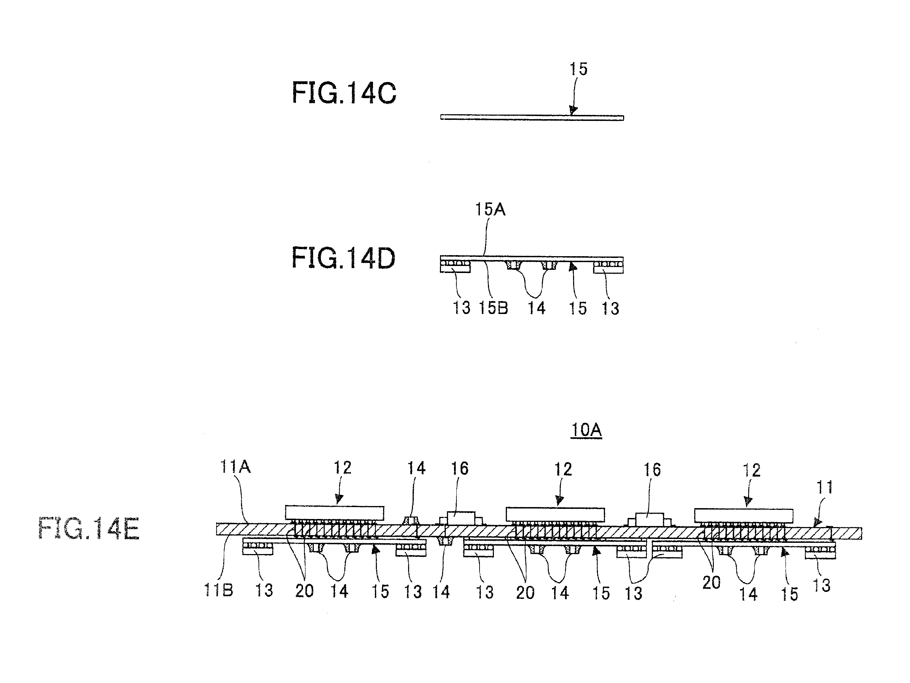

Next, a process of mounting electronic components on the flexible substrate 15 is described. This process may be performed in parallel with the process of mounting electronic components on the printed circuit board 11. In order to mount electronic components on the flexible substrate 15, solder paste is applied to the fourth lands 39 and 40 formed on the back side 15B of the flexible substrate 15 as illustrated in FIG. 14C. Next, the BGA type memories 13 are tentatively fixed to the fourth lands 39 and the bypass capacitors 14 are tentatively fixed to the fourth lands 40.

Next, a reflow process is performed on the flexible substrate 15 on which the electronic components such as the BGA type memories 13 and the bypass capacitors 14 have been tentatively fixed, in order to solder-mount the electronic components such as the BGA type memories 13 onto the back side 15B of the flexible substrate 15. FIG. 14D illustrates the electronic components such as the BGA type memories 13 being mounted on the flexible substrate 15.

When electronic components have been mounted on the printed circuit board 11 and the flexible substrate 15 in the above-described manner, the solder paste 43A is applied to the positions where the second lands 37 for connecting to the flexible substrate 15 are formed on the back side 11B of the printed circuit board 11. Furthermore, the fixing resin 22 having thermosetting properties is applied to predetermined positions on the back side 11B of the printed circuit board 11 (the solder paste 43A and the fixing resin 22 are not illustrated in FIGS. 14A through 14E).

Next, the flexible substrate 15 is tentatively fixed to the back side 11B of the printed circuit board 11. In the tentatively-fixed state, the solder paste 43A is in contact with the third lands 38 on the flexible substrate 15, and the fixing resin 22 is also in contact with the flexible substrate 15.

Next, a reflow process is performed on the printed circuit board 11 on which the flexible substrate 15 is tentatively fixed, in order to solder-mount the second lands 37 of the printed circuit board 11 onto the third lands 38 of the flexible substrate 15. Accordingly, the flexible substrate 15 is solder-fixed onto the printed circuit board 11 by the solder 43. Furthermore, the fixing resin 22 also is thermally-hardened in response to heat, and therefore the flexible substrate 15 is adhered to the printed circuit board 11 by the fixing resin 22.

In the present modification, the printed circuit board unit 10A is fabricated by performing the above procedures. FIG. 14E illustrates the printed circuit board unit 10A fabricated according to the present modification. The printed circuit board unit 10A having the same structure may be fabricated, by performing either the fabrication method according to the present modification or the fabrication method described with reference to FIGS. 8A through FIG. 13.

However, according to the present modification, when the electronic components such as the BGA type integrated circuits 12 are mounted on the printed circuit board 11, the electronic components such as the BGA type integrated circuits 12 may be tested. Likewise, when electronic components such as the BGA type memories 13 are mounted on the flexible substrate 15, the electronic components such as the BGA type memories 13 may be tested. In this manner, according to the present modification, the electronic components may be tested before the flexible substrate 15 is disposed on the printed circuit board 11.

Next, a description is given of a printed circuit board unit according to a second embodiment of the present invention.

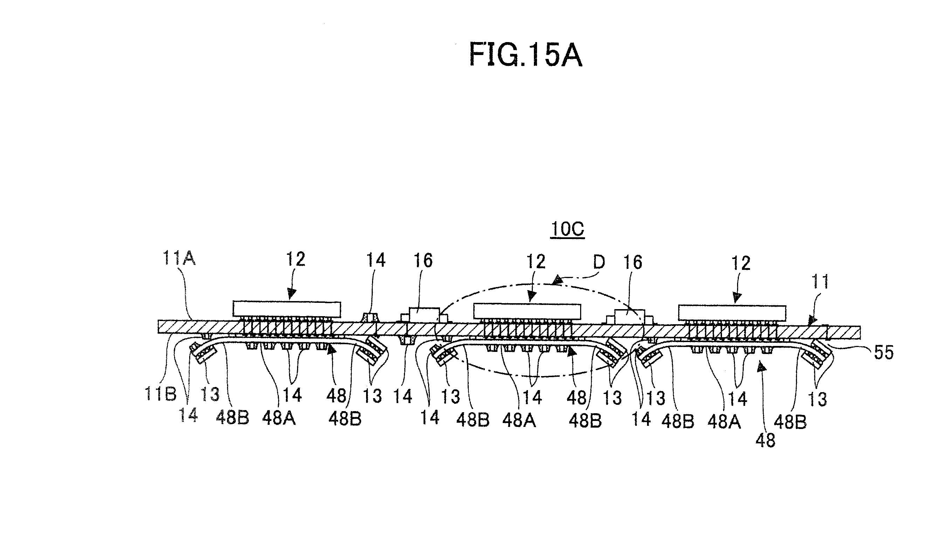

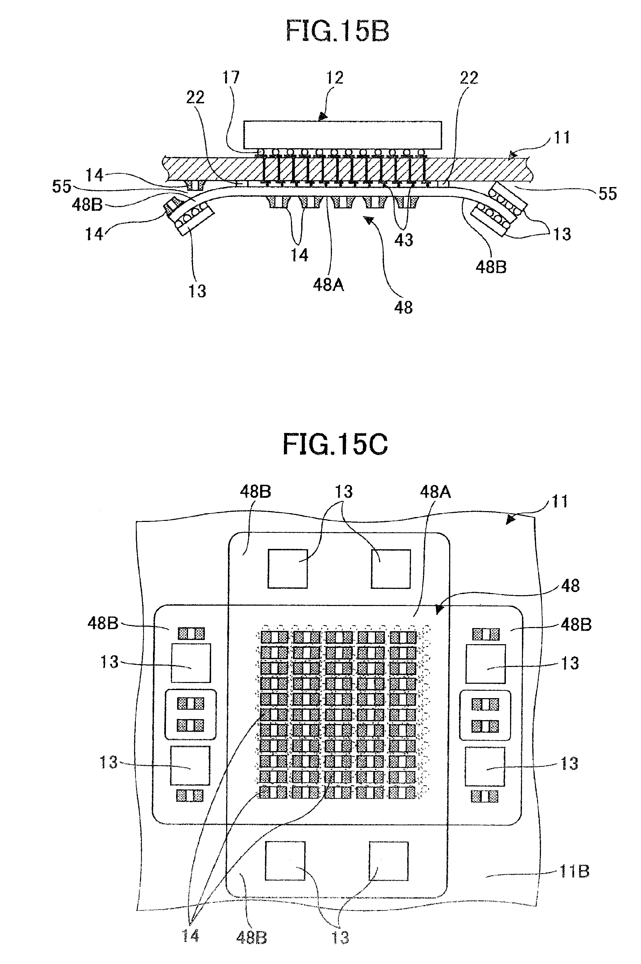

FIGS. 15A through 15C are for describing a printed circuit board unit 10C according to the second embodiment. In FIGS. 15A through 15C, elements corresponding to those of the printed circuit board unit 10A according to the first embodiment illustrated in FIGS. 2A through 3 are denoted by the same reference numerals and are not further described.

A flexible substrate 48 disposed on the printed circuit board unit 10C according to the present embodiment includes a fixed part 48A fixed to the back side 11B of the printed circuit board 11, and the extending part 48B, which extends outward from the fixed part 48A and which is separated from the printed circuit board 11.

The flexible substrate 48 serving as a slave substrate in the present embodiment is a resin film having insulating properties and flexibility such as a polyimide film. The same third lands 38 and fourth lands 39 and 40 as those illustrated in FIGS. 9A through 9C are formed on the resin film. Furthermore, the flexible substrate 48 has a rectangular fixed part 48A that is fixed to the printed circuit board 11, and the extending parts 48B that extend from the outer peripherals of the fixed part 48A toward the outside.

The fourth lands 40 are formed on the back side of the fixed part 48A, and the bypass capacitors 14 are mounted on these fourth lands 40. The third lands 38 for connecting to the printed circuit board 11 are formed on the front side of the fixed part 48A. The third lands 38 are soldered to the second lands 37 formed on the back side 11B of the printed circuit board 11 for connecting to the flexible substrate 15. Accordingly, the flexible substrate 48 is fixed to the printed circuit board 11. The method of connecting the second lands 37 formed on the printed circuit board 11 to the third lands 38 formed on the flexible substrate 15 is not limited to soldering; a pressure bonding method or an ACF (Anisotropic Conductive Film) connecting method are also applicable.

The description of the printed circuit board unit 10C continues below. On the front side of the extending part 48B, the bypass capacitor 14 or the BGA type memory 13 is mounted. Meanwhile, on the back side of the extending part 48B, the BGA type memory 13 is mounted. Accordingly, as illustrated in FIGS. 15A and 15B, the BGA type memories 13 and the bypass capacitors 14 are formed on both the front side and the back side of the flexible substrate 48.

In the printed circuit board unit 10C according to the present embodiment, the extending parts 48B of the flexible substrate 48 are not fixed to the printed circuit board 11. Rather, the extending parts 48B are separated from the back side 11B of the printed circuit board 11. Accordingly, an empty space 55 is formed between the back side 11B of the printed circuit board 11 and the extending part 48B of the flexible substrate 48 (see FIG. 15B), and therefore components may be mounted in a very dense manner.

In the printed circuit board unit 10A according to the first embodiment, the openings 19 are formed in the flexible substrate 15, and the bypass capacitors 14 mounted on the printed circuit board 11 are positioned in the openings 19, so that the components are densely mounted (see FIG. 2C).

Meanwhile, in the printed circuit board unit 10C according to the second embodiment, the extending part 48B is separated from the printed circuit board 11. Therefore, the electric components may be provided on both the front side and the back side of the extending part 48B, and also on the back side 11B of she printed circuit board 11 facing the extending part 48B. In the example illustrated in FIG. 15B, the bypass capacitor 14 is mounted on the front side of the extending part 48B positioned on the left side as viewed in FIG. 15B, the BGA type memory 13 is mounted on the back side of the extending part 48B positioned on the left side as viewed in FIG. 15B, and the bypass capacitor 14 is mounted on the back side 11B of the printed circuit board 11.

As described above, in the printed circuit board unit 10C according to the present embodiment, the electronic components are mounted even more efficiently compared to the case of the printed circuit board unit 10A.

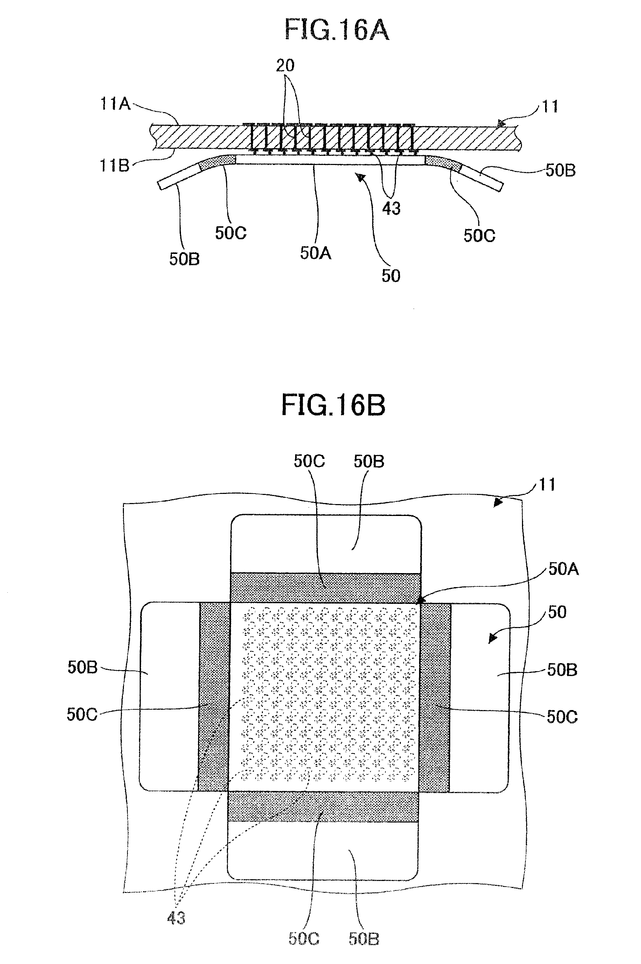

FIGS. 16A and 16B illustrate an example where a rigid flexible substrate 50 is used instead of the flexible substrate 48, in the printed circuit board unit 10C according to the second embodiment.

A fixed part 50A of the rigid flexible substrate 50 is fixed to the printed circuit board 11. On extending parts 50B of the rigid flexible substrate 50, electronic components such as the BGA type memory 13 may be mounted. The fixed part 50A and the extending parts 50B are made of a hard and highly rigid material such as glass epoxy. A flexible part 50C for connecting the fixed part 50A and each of the extending parts 50B is formed with a flexible substrate. The fixed part 50A and the extending part 50B are highly rigid, and therefore the process of solder-mounting the fixed part 50A to the printed circuit board 11 and the process of mounting electronic components such as the BGA type memory 13 may be reliably performed.

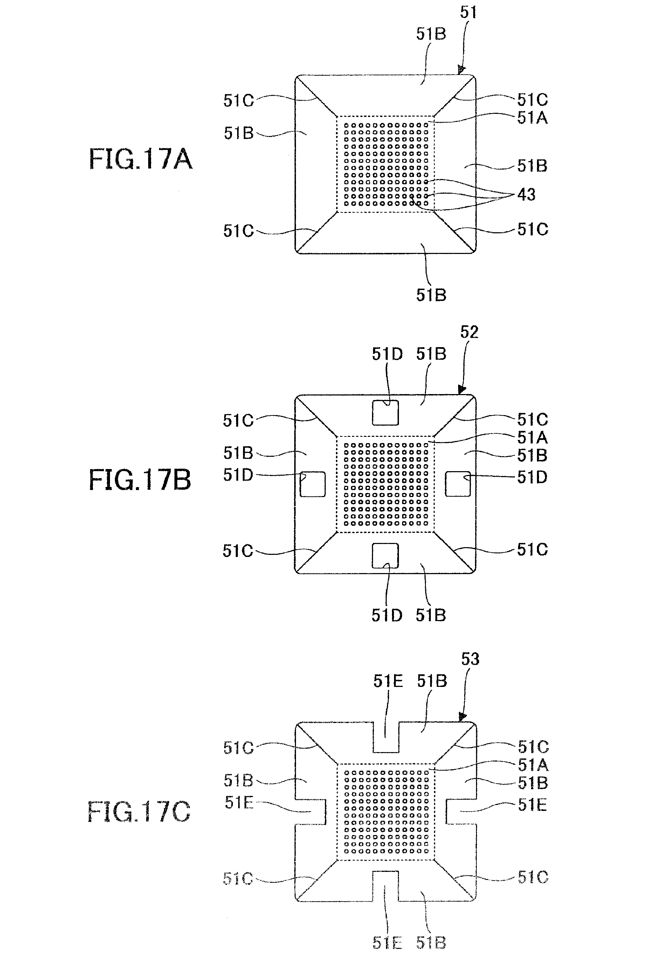

FIGS. 17A through 17C illustrate various flexible substrates that are applicable to the printed circuit board units 10A, 10B, and 10C. The printed circuit board unit 10C illustrated in FIGS. 15A through 15C has a substantially cross shape, in which the extending parts 48B are extending from the four sides of the fixed part 48A that has a square shape. The fixed part 48A and the extending parts 48B are formed as a single body.

Meanwhile, a flexible substrate 51 illustrated in FIG. 17A is formed by making incisions 51C from the four corners of the substantially square film substrate toward the center of the substrate, at an angle of 45° with respect to each side. By making such incisions 51C, each part between two incisions 51C may be bent, and each of these bent parts is used as an extending part 51B.

Furthermore, a square part including the tips of the incisions 51C as apexes (the part surrounded by dotted lines in FIGS. 17A through 17C) is used as a fixed part 51A. In the present embodiment, the flexible substrate 51 including the fixed part 51A and the extending parts 51B are formed only be making the incisions 51C in the four corners, and therefore the flexible substrate 51 may be easily fabricated.

A flexible substrate 52 illustrated in FIG. 17B has openings 51D formed in the extending parts 51B. A flexible substrate 53 illustrated in FIG. 17C has notches 51E formed in the extending parts 51B. The openings 51D and the notches 51E may be formed together with the incisions 51C, thus simplifying the fabrication procedures of the flexible substrates 52 and 53.

According to an embodiment of the present invention, in a printed circuit board unit, a flexible substrate is provided on the back side of a printed circuit board in a region corresponding to where an integrated circuit is mounted on the front side of the printed circuit board. By using the flexible substrate, components may be mounted efficiently.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A printed circuit board unit **characterized by**:
a printed circuit board including through holes arranged in a grid array on which an integrated circuit is mounted; and
a flexible substrate provided on a back side of the printed circuit board in such a manner as to cover the through holes, wherein
first lands to which the integrated circuit is connected are formed on a front side of the printed circuit board, the first lands being connected to first ends of the through holes,
second lands to which the flexible substrate is connected are formed on the back side of the printed circuit board, the second lands being connected to second ends of the through holes,
third lands are formed on a front side of the flexible substrate so as to face the second lands of the printed circuit board, and
fourth lands are formed on a back side of the flexible substrate, the fourth lands being electrically connected to the third lands.

2. The printed circuit board unit according to claim 1, wherein
at least one of the third lands is electrically connected to the fourth lands.

3. The printed circuit board unit according to claim 1, wherein
the third lands of the flexible substrate are reflow-solder-mounted to the second lands of the printed circuit board.

4. The printed circuit board unit according to claim 1, wherein
the flexible substrate is a rigid flexible substrate.

5. The printed circuit board unit according to claim 1, wherein
on the fourth lands of the flexible substrate, at least one of a bypass capacitor, a termination resistor, and a memory member is mounted.

6. The printed circuit board unit according to claim 5, wherein
among the fourth lands, lands on which the bypass capacitor is mounted are arranged at a pitch larger than a pitch at which the third lands are arranged on the front side of the flexible substrate.

7. The printed circuit board unit according to claim 2 or 3, wherein
the flexible substrate is larger than a region where the integrated circuit is mounted on the printed circuit board, and the flexible substrate includes an extending part that extends outside from a region in which the third lands are reflow-solder-mounted to the second lands.

8. The printed circuit board unit according to claim 7, wherein
the extending part of the flexible substrate is fixed to the back side of the printed circuit board with an adhesive.

9. The printed circuit board unit according to claim 7, wherein
at least one of the fourth lands of the flexible substrate is arranged on the extending part, and
a memory member is mounted on the at least one of the fourth lands on the extending part.

10. The printed circuit board unit according to claim 9, wherein
memory members are mounted on both sides of the extending part.

11. The printed circuit board unit according to claim 7, wherein
an opening is formed in the extending part of the flexible substrate.

12. The printed circuit board unit according to any one of claims 1 through 12, wherein
the integrated circuit mounted on the front side of the printed circuit board is a BGA package.

13. An electronic device in which the printed circuit board according to any one of claims 1 through 12 is installed.
